# EUROPÄISCHE PATENTSCHRIFT

(11) **EP 3 230 707 B1**
(45) Veröffentlichungstag und Bekanntmachung des Hinweises auf die Patenterteilung: **15.07.2020**
(21) Anmeldenummer: 15804719.1
(22) Anmeldetag: 30.11.2015
(51) Int. Cl.: G01L 19/06, F16K 24/00, F16K 17/04, H05K 5/06, H05K 5/02

(54) **DRUCKAUSGLEICHSELEMENT FÜR EIN FELDGERÄT DER AUTOMATISIERUNGSTECHNIK**
PRESSURE EQUALIZATION ELEMENT FOR A FIELD DEVICE USED IN AUTOMATION TECHNOLOGY
ÉLÉMENT DE COMPENSATION DE PRESSION POUR UN APPAREIL DE CHAMP DE LA TECHNIQUE D'AUTOMATION

(30) Priorität: 12.12.2014 DE 102014118541
(43) Veröffentlichungstag der Anmeldung: 18.10.2017
(73) Patentinhaber: Endress+Hauser SE+Co. KG, 79689 Maulburg (DE)
(72) Erfinder: POL, Ioan-Mircea, 79539 Lörrach (DE)
(74) Vertreter: Andres, Angelika Maria
(86) Internationale Anmeldenummer: PCT/EP2015/078011
(87) Internationale Veröffentlichungsnummer: WO 2016/091631

(56) Entgegenhaltungen:
- EP-A1- 1 997 685
- DE-U1-202008 005 548
- DE-U1-202008 005 548
- DE-U1-202008 007 375
- DE-U1-202008 007 375

## Beschreibung

Die Erfindung betrifft ein Druckausgleichselement.

Zur Erfassung von Prozessvariablen in der Automatisierungstechnik dienen Sensoren, die beispielsweise in Füllstandsmessgeräte, Durchflussmessgeräte, Druck- und Temperaturmessgeräte, Analysemessgeräte, usw. integriert sind. Die Geräte erfassen die entsprechenden Prozessvariablen Füllstand, Durchfluss, Druck, Temperatur, Analysedaten, wie pH-Wert, Trübung oder Leitfähigkeit. Zur Beeinflussung von Prozessvariablen dienen Aktoren, wie zum Beispiel Ventile oder Pumpen, über die der Durchfluss einer Flüssigkeit in einem Rohrleitungsabschnitt bzw. der Füllstand in einem Behälter geändert werden kann. Sensoren und Aktoren werden allgemein als Feldgeräte bezeichnet. Als Feldgeräte werden in Verbindung mit der Erfindung somit alle Geräte bezeichnet, die prozessnah eingesetzt werden und die prozessrelevante Informationen liefern oder verarbeiten.

Aus der DE 10 2012 109 632 A1 ist ein Messaufnehmer zur messtechnischen Erfassung eines zu messenden Drucks als Relativdruck gegenüber einem in der Umgebung des Messaufnehmers herrschenden Referenzdruck bekannt geworden. Der Messaufnehmer weist folgende Komponenten auf: ein Gehäuse, einen in dem Gehäuse angeordneten Relativdrucksensor, eine Druckzufuhr, über die dem Relativdrucksensor der zu messende Druck zugeführt wird, und eine Referenzdruckzufuhr, über die dem Relativdrucksensor der Referenzdruck zugeführt wird. Die Referenzdruckzufuhr mündet in einer Öffnung in einer Außenwand des Gehäuses, auf dessen Außenseite der Referenzdruck wirkt. In einem der Öffnung zugewandten Endbereich ist ein Verschluss eingesetzt, der einen auf der von der Öffnung abgewandten Seite des Verschlusses befindlichen Innenraum der Referenzdruckzufuhr nach außen verschließt. Weiterhin ist ein Kapillarrohr vorgesehen, durch das hindurch ein auf der vom Relativdrucksensor abgewandten Seite des Verschlusses befindlicher Bereich der Referenzdruckzufuhr über eine durch den Verschluss hindurch führende Bohrung mit dem vom Verschluss verschlossenen Innenraum der Referenzdruckzufuhr verbunden ist. Durch diese Lösung wird verhindert, dass Feuchtigkeit ins Innere des Referenzdrucksensors gelangt. Hierbei ist zu beachten, dass das Eindringen von Feuchtigkeit die Messgenauigkeit eines Messaufnehmers erheblich beeinträchtigt und im Extremfall sogar zum vollständigen Ausfall des Druckmessaufnehmers führen kann.

Aus der DE 20 2011 108 899 U1 ist ein Relativdruckmessumformer bekannt geworden, der ein Gehäuse, einen Drucksensor mit einem Druckmesswandler zum Bereitstellen eines druckabhängigen elektrischen Primärsignals und eine elektronische Schaltung zum Treiben des Druckmesswandlers und zum Verarbeiten des Primärsignals, um ein primärsignalabhängiges Signal als Messwert an einem Ausgang der elektronischen Schaltung bereitzustellen. Der Drucksensor und die elektronische Schaltung sind in dem Gehäuse angeordnet. Das Gehäuse weist eine Mediendrucköffnung und einen Referenzluftpfad auf, wobei der Drucksensor über die Mediendrucköffnung mit dem Mediendruck und über den Referenzluftpfad mit der Umgebungsluft zum Bereitstellen des Atmosphärendrucks beaufschlagbar ist. Der Referenzluftpfad umfasst ein Filterelement, das den Drucksensor vor dem Eindringen von Feuchtigkeit schützt. Der Referenzluftpfad weist mindestens zwei Referenzluftöffnungen in einer Oberfläche des Gehäuses auf, wobei von jedem Filterelement jeweils mindestens ein Öffnungspfad zu der Referenzluftöffnung verläuft. Die Öffnungspfade sind jeweils so zueinander positioniert und orientiert, dass von mindestens einem Filterelement ein Öffnungspfad ohne einen Anstieg zu einer Referenzluftöffnung verläuft. Somit kann Wasser von dem Filterelement abfließen.

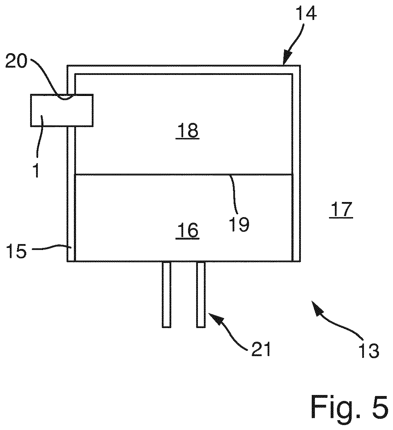

Aus der DE 10 2008 018 900 A1 ist eine Druckausgleichsverschraubung mit Rohrmembran und einstellbarem Volumenstrom bekannt geworden. Die Druckausgleichsverschraubung weist eine atmungsaktive semipermeable Durchführung auf und besteht aus einem Unterteil und einem Deckel als Oberteil. Beide Teile sind miteinander verbunden. Das Unterteil wird von einem Hohlzylinder gebildet. Zwischen der Oberkante des Unterteils und dem Deckel sind radiale Lüftungskanäle vorgesehen. Die Rohrmembran ist in dem Hohlzylinder des Unterteils angeordnet. Die axiale Abmessung der Rohrmembran ist so gewählt, dass ihre Oberkante in Kontakt mit der Innenfläche des Deckels und ihre Unterkante in Kontakt mit einer den Hohlzylinder des Unterteils begrenzenden Innenfläche ist. Da die flexible Rohrmembran in radialer Richtung keine definierte Auflagefläche hat und nicht formschlüssig in der Druckausgleichsverschraubung befestigt ist, besteht die Gefahr, dass ein aus- oder einströmendes gasförmiges Medium nicht den in Fig. 5 gekennzeichneten Weg nimmt, sondern an der Ober- bzw. Unterkante der Rohrmembran entlang strömt und das Gehäuse ungefiltert durch die radialen Öffnung 49 verlässt bzw. ungefiltert in das Gehäuse hineinströmt.

Aus der EP 1 997 685 A1 ist ein Ventilationselement bekannt geworden.

Der Erfindung liegt die Aufgabe zugrunde, ein Druckausgleichselement vorzuschlagen, das unabhängig von der Montagelage eines Feldgeräts der Automatisierungstechnik zuverlässig seine Filterfunktion erfüllt.

Die Aufgabe wird gelöst durch ein Druckausgleichselement zum Ausgleich von Druckunterschiedenen zwischen zwei einem Feldgerät der Automatisierungstechnik zugeordneten Raumbereichen mit einem Grundkörper, der aus einem Befestigungselement mit einer axialen Bohrung, das zur Befestigung des Druckausgleichselement in einer Wandung des Feldgeräts dient, und einer scheibenförmigen Trägerkomponente mit einer seitlichen Endfläche besteht, wobei in der scheibenförmigen Trägerkomponente eine vorgegebene Anzahl von mit der axialen Bohrung korrespondierenden im Wesentlichen radial verlaufenden Ausnehmungen vorgesehen ist, wobei die radial verlaufenden Ausnehmungen um einen definierten Winkelversatz zueinander versetzt sind, und wobei die radial verlaufenden Ausnehmungen im Bereich der seitlichen Endfläche der scheibenförmigen Trägerkomponente mit einer flüssigkeitssperrenden gasdurchlässigen Membran versehen sind. Erfindungsgemäß ist eine Schutzkappe vorgesehen, die die scheibenförmige Trägerkomponente im Bereich der äußeren Stirnfläche und der seitlichen Endfläche abdeckt. Hierdurch ist die Membran gegen Verschmutzung, Spritzwasser und mechanische Beschädigung effektiv geschützt, ohne dass ihre Filterfunktion gemindert wird.
Die Endfläche ist bei einer Trägerkomponente mit kreisförmigem Querschnitt ringförmig bzw. es handelt sich um eine radiale Endfläche, bei einem eckigen Querschnitt besteht die Endfläche aus einer vorgegebenen Anzahl von miteinander verbundenen rechteckförmigen Teilstücken.

Das erfindungsgemäße Druckausgleichselement kann die Druckausgleichsfunktion unabhängig von der Montageposition des Feldgeräts erfüllen, da es stets mehrere "Atemwege" zur Verfügung hat. Den mehreren Atemwegen entsprechen die radial angeordneten Ausnehmungen in der scheibenförmigen Trägerkomponente, die mit der axialen Bohrung verbunden sind. Selbst im schlimmsten Fall, wenn eine der radial angeordneten Ausnehmungen - also ein Atemweg - verstopft ist, kann der Druckausgleich über eine nicht verstopfte redundante Ausnehmung ungehindert erfolgen. Die Verstopfung kann dadurch hervorgerufen werden, dass sich Kondenswasser auf der Membran ansammelt und/oder dass sich Schmutz oder Staub auf der ablagern.
Bevorzugt sind an der Schutzkappe im Bereich der Stirnfläche Öffnungsschlitze vorgesehen, über die - in Abhängigkeit von der Montagelage des Druckausgleichselements - ggf. Kondenswasser abtropfen kann.

Die Anzahl der radial verlaufenden und in der seitlichen Endfläche endenden Ausnehmungen kann beliebig sein, allerdings müssen zumindest zwei Ausnehmungen vorgesehen sein. Der Winkelversatz zwischen den radial verlaufenden Ausnehmungen kann gleichfalls beliebig sein. Bevorzugt beträgt der Winkelversatz bei einer Anzahl n von radial verlaufenden Ausnehmungen 360°/n. Daher sind zwei Ausnehmungen bevorzugt diametral angeordnet, drei Ausnehmungen weisen einen Winkelversatz von 120° und 4 Ausnehmungen einen Winkelversatz von 90° auf.

Das erfindungsgemäße Durchausgleichselement kann aus Kunststoff und/oder Metall gefertigt sein.

Erfindungsgemäß weist die scheibenförmige Trägerkomponente in zwei axial zueinander versetzten Bereichen der seitlichen Endfläche jeweils eine Anschlagkante auf. Erfindungsgemäß ist die Membran als ringförmiges Band ausgestaltet und zwischen den beiden Anschlagkanten befestigt. Die Fixierung an der seitlichen Endfläche kann beispielsweise durch zusätzliche Klebepunkte an der Membran verstärkt werden. Diese Ausgestaltung ermöglicht es, dass die Membran alle Ausnehmungen gleichzeitig verschließt. Selbstverständlich kann die Membran auch aus Einzelteilen bestehen, die so angeordnet sind, dass sie die Ausnehmungen im Bereich der Seitenfläche verschließen.

Die Membran ist bevorzugt so ausgestaltet, dass sie atmungsaktiv und unidirektional wasserdampfdurchlässig ist. Außerdem besteht sie bevorzugt aus einem wasserabweisenden, hydrophoben Material. Bevorzugt ist die Membran aus Goretex gefertigt.

Darüber hinaus betrifft die Erfindung ein Feldgerät der Automatisierungs technik mit zumindest einem ersten Innenraum, wobei ein erfindungsgemäßes Druckausgleichselement in der Wandung des Feldgeräts angeordnet ist, die den Innenraum von der Umgebung des Feldgeräts trennt. Bei dieser Ausgestaltung befindet sich das Druckausgleichselement also in der Außenwand des Feldgeräts.

Desweiteren bezieht sich die Erfindung auf ein Feldgerät der Automatisierungstechnik mit zumindest einem ersten Innenraum und einem zweiten Innenraum, wobei der erste Innenraum und der zweite Innenraum durch eine Zwischenwand voneinander getrennt sind, und wobei ein erfindungsgemäßes Druckausgleichselement in der Außenwand eines der beiden Innenräume angeordnet ist. Entsprechende Lösungen sind unter der Bezeichnung Dual Seal bekannt geworden.

Weiterhin wird als Erfindung ein Relativdruckmessaufnehmer zur messtechnischen Erfassung eines zu messenden Drucks als Relativdruck gegenüber einem in der Umgebung des Messaufnehmers herrschenden Referenzdruck mit einem in einem Gehäuse angeordneten Relativdrucksensor, einer Druckzufuhr, über die dem Relativdrucksensor der zu messende Druck zugeführt wird, und einer Referenzdruckzufuhr, über die dem Relativdrucksensor der Referenzdruck zugeführt wird. Die Referenzdruckzufuhr mündet in einer Öffnung in einer Außenwand des Gehäuses. In die Öffnung oder in die Referenzdruckzufuhr ist ein erfindungsgemäßes Druckausgleichselement eingesetzt.

Die Erfindung wird anhand der nachfolgenden Figuren näher erläutert. Es zeigt:
Fig. 1: eine perspektivische Darstellung einer Ausführungsform des erfindungsgemäßen Druckausgleichselements,
Fig. 2: einen Längsschnitt gemäß der Kennzeichnung A-A durch das in Fig. 1 gezeigte Druckausgleichselement,
Fig. 3: eine Explosionsdarstellung der in Fig. 1 gezeigten Ausführungsform des erfindungsgemäßen Druckausgleichselements,
Fig. 4: einen Schnitt durch die in Fig. 3 gezeigte Ausgestaltung des Druckausgleichselements gemäß der Kennzeichnung B-B und
Fig. 5: eine schematische Darstellung eines Feldgeräts mit einem erfindungsgemäßen Druckausgleichselement.

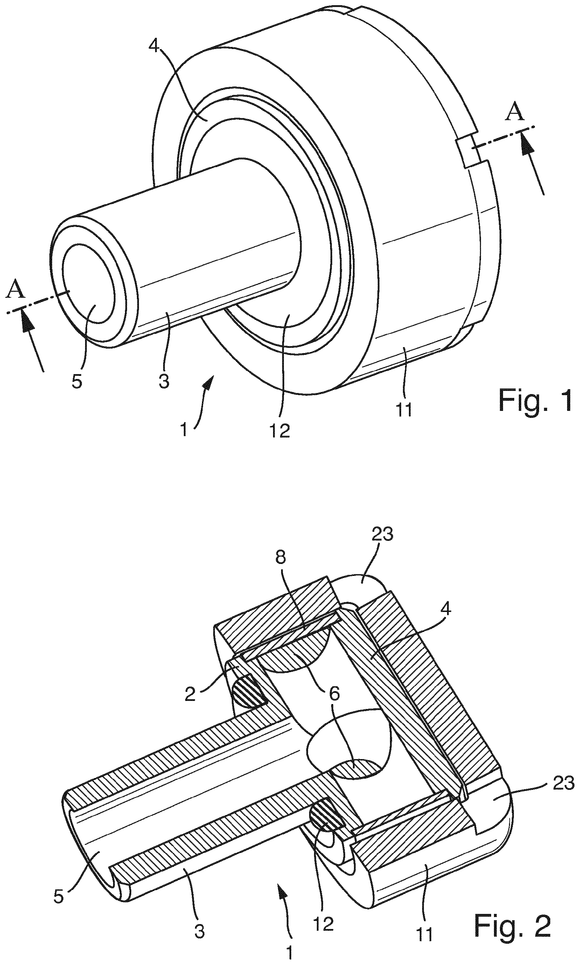

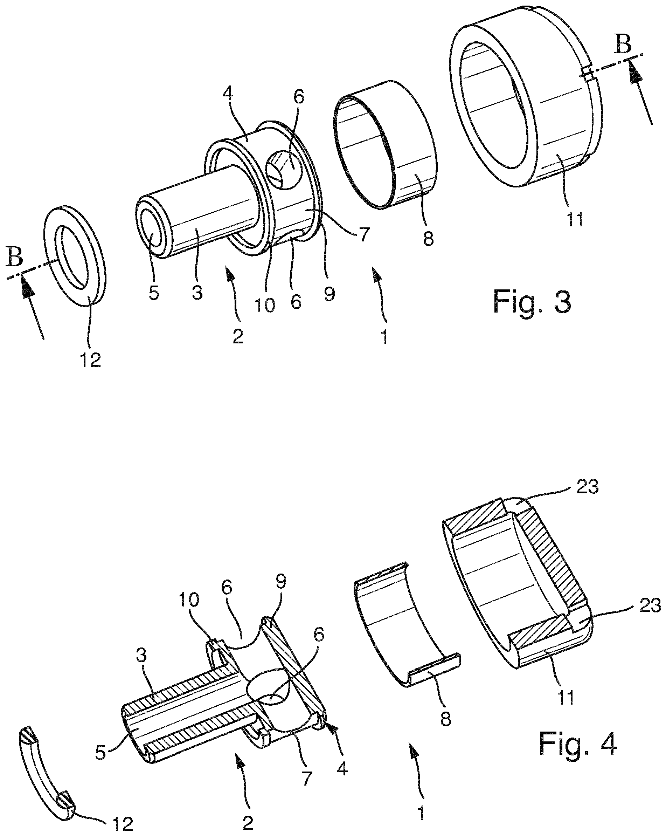

Eine bevorzugte Ausgestaltung des erfindungsgemäßen Druckausgleichselements 1 wird anhand der nachfolgenden Figuren näher erläutert. Fig. 1 zeigt eine perspektivische Darstellung, Fig. 2 einen Längsschnitt gemäß der Kennzeichnung A-A in Fig. 1, Fig. 3 eine Explosionsdarstellung der in Fig. 1 gezeigten Ausführungsform und Fig. 4 einen Längsschnitt durch die in Fig. 3 gezeigte Ausgestaltung gemäß der Kennzeichnung B-B. Das erfindungsgemäße Druckausgleichselement 1 dient zum Ausgleich von Druckunterschiedenen zwischen zwei einem Feldgerät 13 der Automatisierungstechnik zugeordneten Raumbereichen. Es weist einen Grundkörper 2 auf, der aus einem länglichen Befestigungselement 3 mit einer axialen Bohrung 5, das zur Befestigung des Druckausgleichselement 1 in einer Wandung 15 des Feldgeräts 13 dient, einer scheibenförmigen Trägerkomponente 4 und einer Schutzkappe 11. Die Befestigung des Druckausgleichselements 1 in der Wandung 15 des Feldgeräts 13 selbst erfolgt beispielsweise über eine Verschraubung, einen Klemmung oder eine Klebung.

Die Schutzkappe 11 ist im zusammengebauten Zustand des Druckausgleichselements 1 fest mit der scheibenförmigen Trägerkomponente 4 verbunden. Die permanente oder lösbare Verbindung erfolgt entweder über eine Klebung, ein Verschweißen, z.B. ein Punktschweißen, eine mechanische Schraubverbindung oder über elastische Krallen, die im Bereich der freien Unterkante der Schutzkappe 11 vorgesehen sind. Entsprechende permanente und lösbare Befestigungen sind einer fachlich qualifizierten Person bekannt, so dass sich nähere Erläuterungen erübrigen.

Vorteilhaft ist es, wenn im Deckelbereich der Schutzkappe 11 Öffnungen 22 vorgesehen sind, über die ggf. sich bildendes Kondensat abfließen kann.

Die scheibenförmigen Trägerkomponente 4 wird durch eine seitliche Endfläche 7 begrenzt. In der scheibenförmigen Trägerkomponente 4 ist eine vorgegebene Anzahl (n, mit n > 2) von mit der axialen Bohrung 5 der Befestigungskomponente 3 korrespondierenden im Wesentlichen radial verlaufenden Ausnehmungen 6 vorgesehen. Die radial verlaufenden als Bohrungen ausgegestalteten Ausnehmungen 6 sind um einen definierten Winkelversatz zueinander versetzt. Im Bereich der seitlichen Endfläche 7 sind die radial verlaufenden Ausnehmungen 6 der scheibenförmigen Trägerkomponente 4 mit einer flüssigkeitssperrenden gasdurchlässigen Membran 8 versehen.

Bei der in den Figuren dargestellten Ausführungsform weist die scheibenförmige Trägerkomponente 4 vier radial angeordnete Ausnehmungen 6 auf. Diese sind im Wesentlichen unter einem Winkelversatz von 90° zueinander angeordnet.

Im gezeigten Beispiel sind Ober- und Unterkante der seitlichen Endfläche 7 als axiale Anschlagkanten 9, 10 ausgebildet, weiterhin dient die seitliche Endfläche 7 als solche als Anlagefläche für die Membran 8 . Zwischen den beiden Anschlagkanten 9, 10 ist im dargestellten Fall die ringförmige Membran 8 positioniert. Die Membran 8 verschließt alle Ausnehmungen 6 auf der seitlichen Endfläche 7 der scheibenförmigen Trägerkomponente 4 . Bei der Membran 8 handelt es sich um eine unidirektional wasserdampfdurchlässige, wasserabweisende, atmungsaktive Membran. Diese ist bevorzugt aus Goretex gefertigt. Es versteht sich von selbst, dass es genügt, wenn die atmungsaktive Membran 8 die Ausnehmungen 6 abdeckt. Bevorzugt ist die ringförmige Membran 8 oder sind die die Ausnehmungen 6 abdeckenden Membranstücke fest mit der Oberfläche bzw. mit Teilen der Oberfläche der seitlichen Endfläche 7 verbunden. Die Dichtung 12 stellt sicher, dass der Strom von gasförmigem Medium ausschließlich über die radial angeordneten Ausnehmungen 6 erfolgt, die mit einer Membran 8 versehen sind.

Fig. 5 zeigt eine schematische Darstellung eines Feldgeräts 13 mit einem erfindungsgemäßen Druckausgleichselement 1. Im gezeigten Fall handelt es sich bei dem Feldgerät 13 um einen vibronischen Sensor. Entsprechende Sensoren werden von der Anmelderin in unterschiedlichen Ausgestaltungen für unterschiedliche Anwendungen angeboten und vertrieben.

Wie jeder Sensor zur Bestimmung und Überwachung einer Prozessgröße - hier des Grenzstands eines Mediums in einem Behälter, der Dichte und/oder der Viskosität eines Mediums - weist das Feldgerät 13 ein Gehäuse 14, in dem sich die nicht dargestellten Elektronikkomponenten befinden, und ein Sensorelement 21 auf.

In der Außenwand 15 des Gehäuses 14, die den Innenraum 16; 18 mit den Elektronikkomponenten von der äußeren Umgebung 17 trennt, ist das erfindungsgemäße Druckausgleichselement 1 in einer Öffnung 20 angeordnet. In der Fig. 5 ist desweiteren eine Ausgestaltung eines Feldgeräts 13 mit zwei Innenräumen 16, 18 gezeigt. Je nach Ausgestaltung des Feldgeräts 13 und je nach Anforderungen, die an das Feldgerät 13 gestellt werden, ist zumindest ein erfindungsgemäßes Druckausgleichselement 1 in der Außenwand des Innenraums 16 und/oder des Innenraums 18 positioniert.

### Bezugszeichenliste

- 1: Druckausgleichselement
- 2: Grundkörper
- 3: Befestigungselement
- 4: scheibenförmige Trägerkomponente
- 5: axiale Bohrung
- 6: radial angeordnete Ausnehmung
- 7: seitliche Endfläche
- 8: Membran
- 9: Anschlagkante
- 10: Anschlagkante
- 11: Schutzkappe
- 12: Dichtung
- 13: Feldgerät
- 14: Gehäuse
- 15: Wandung
- 16: erster Innenraum
- 17: äußere Umgebung
- 18: zweiter Innenraum
- 19: Zwischenwand
- 20: Öffnung
- 21: Sensorelement
- 22: Stirnfläche
- 23: Öffnungsschlitz

## Patentansprüche

1. Druckausgleichselement (1) zum Ausgleich von Druckunterschieden zwischen zumindest zwei einem Feldgerät (13) der Automatisierungstechnik zugeordneten Raumbereichen
mit einem Grundkörper (2), der aus einem Befestigungselement (3) mit einer axialen Bohrung (5), das zur Befestigung des Druckausgleichselement (1) in einer Wandung des Feldgeräts dient, und einer scheibenförmigen Trägerkomponente (4) mit einer seitlichen Endfläche (7) besteht,
wobei die scheibenförmige Trägerkomponente (4) in zwei axial zueinander versetzten Bereichen der Endfläche (7) jeweils eine Anschlagkante (9, 10) aufweist,
wobei in der scheibenförmigen Trägerkomponente (4) eine vorgegebene Anzahl (n, mit n ≥ 2) von mit der axialen Bohrung (5) korrespondierenden radial verlaufenden Ausnehmungen (6) vorgesehen ist,
wobei die radial verlaufenden Ausnehmungen (6) um einen definierten Winkelversatz zueinander versetzt sind,
wobei die radial verlaufenden Ausnehmungen (6) im Bereich der seitlichen Endfläche (7) der scheibenförmigen Trägerkomponente (4) mit einer flüssigkeitssperrenden gasdurchlässigen Membran (8) versehen sind,
wobei die Membran (8) ringförmig ausgestaltet ist und zwischen den beiden Anschlagkanten (9, 10) befestigt ist, und
wobei eine Schutzkappe (11) vorgesehen ist, die die scheibenförmige Trägerkomponente (4) im Bereich der Stirnfläche (22) und der seitlichen Endfläche (7) abdeckt.

2. Druckausgleichselement nach Anspruch 1,
wobei der Winkelversatz der Anzahl (n) der radial verlaufenden Ausnehmungen (6) 360º/n beträgt.

3. Druckausgleichselement nach Anspruch 1,
wobei vier radial angeordnete Ausnehmungen (6) in der scheibenförmigen Trägerkomponente (4) vorgesehen sind, die einen Winkelversatz von 90º aufweisen.

4. Druckausgleichselement nach einem oder mehreren der vorhergehenden Ansprüche,
wobei es sich bei der Membran (8) um eine unidirektional wasserdampfdurchlässige, wasserabweisende, atmungsaktive Membran handelt.

5. Feldgerät der Automatisierungstechnik mit zumindest einem ersten Innenraum, wobei ein Druckausgleichselement (1), wie es in zumindest einem der Ansprüche 1-4 beschrieben ist, in der Wandung (15) des Gehäuses (14) des Feldgeräts (13) angeordnet ist, die den Innenraum (16; 18) von der äußeren Umgebung (17) des Feldgeräts (1) trennt.

6. Feldgerät der Automatisierungstechnik mit zumindest einem ersten (16) Innenraum und einem zweiten Innenraum (18), wobei der erste Innenraum (16) und der zweite Innenraum (18) durch eine Zwischenwand (19) voneinander getrennt sind, wobei ein Druckausgleichselement (1), wie es in zumindest einem der Ansprüche 1-4 beschrieben ist, in der Außenwand von zumindest einem der beiden Innenräume (16, 18) angeordnet ist.

7. Relativdruckmessaufnehmer zur messtechnischen Erfassung eines zu messenden Drucks als Relativdruck gegenüber einem in der Umgebung des Messaufnehmer herrschenden Referenzdruck, mit einem in einem Gehäuse (14) angeordneten Relativdrucksensor, einer Druckzufuhr, über die dem Relativdrucksensor der zu messende Druck zugeführt wird, und einer Referenzdruckzufuhr, über die dem Relativdrucksensor der Referenzdruck zugeführt wird, wobei die Referenzdruckzufuhr in einer Öffnung in einer Außenwand des Gehäuses mündet, wobei in die Öffnung oder die Referenzdruckzufuhr ein Druckausgleichselement (1) eingesetzt ist, wie es in zumindest einem der Ansprüche 1-4 beschrieben ist.

## Claims

1. Pressure compensation element (1) designed to compensate for differences in pressure between at least two space zones assigned to a field device (13) used in automation engineering
with a meter body (2), which consists of a securing element (3) with an axial bore (5) which is used to fix the pressure compensation element (1) in a wall of the field device, and a disk-like support component (4) with a side end surface (7), wherein the disk-like support component (4) has a stop edge (9, 10) in two zones - axially offset in relation to one another - of the end surface (7),
wherein a predefined number (n, where n ≥ 2) of recesses (6) that extend radially and correspond to the axial bore (5) is provided in the disk-like support component (4),
wherein the recesses (6) extending radially are offset in relation to one another by an angular offset
wherein the recesses (6) extending radially are provided with a liquid-blocking membrane (8) that allows gas to pass in the area of the side end surface (7) of the disk-like support component (4),
wherein the membrane (8) is designed in the form of a ring and is secured between the two stop edges (9, 10), and
wherein a protective cap (11) is provided that covers the disk-like support component (4) in the area of the front surface (22) and the side end surface (7).

2. Pressure compensation element as claimed in Claim 1,
wherein the angular offset of the number (n) of recesses (6) extending radially is 360°/n.

3. Pressure compensation element as claimed in Claim 1,
wherein four radially arranged recesses (6) are provided in the disk-like support component (4), said recesses having an angular offset of 90°.

4. Pressure compensation element as claimed in one or more of the previous claims,
wherein the membrane (8) is a unidirectional membrane that is permeable to water vapor, water-repellant and breathable.

5. Field device used in automation engineering with at least a first interior space,
wherein a pressure compensation element (1), as described in at least one of the Claims 1 to 4, is arranged in the wall (15) of the housing (14) of the field device (13), said element separating the interior space (16, 18) from the exterior environment (17) of the field device (1).

6. Field device used in automation technology with at least a first interior space (16) and a second interior space (18), wherein the first interior space (16) and the second interior space (18) are separated from one another by an intermediate wall (19), wherein a pressure compensation element (1) as described in at least one of the Claims 1 to 4, is arranged in the exterior wall of at least one of the two interior spaces (16, 18).

7. Gauge pressure sensor for the metrological measurement of a pressure to be measured as a gauge pressure in relation to a reference pressure present in the environment of the sensor, with a gauge pressure sensor arranged in a housing (14), a pressure supply via which the pressure to be measured is supplied to the gauge pressure sensor, and a reference pressure supply via which the reference pressure is supplied to the gauge pressure sensor, wherein the reference pressure supply ends in an opening in an outer wall of the housing, wherein a pressure compensation element (1) is inserted into the opening or the reference pressure supply, as described in at least one of the Claims 1 to 4.

## Revendications

1. Élément de compensation de pression (1) destiné à la compensation de différences de pression entre au moins deux zones d'espace attribuées à un appareil de terrain (13) de la technique d'automatisation
avec un corps de base (2), lequel est constitué d'un élément de fixation (3) avec un perçage axial (5) servant à la fixation de l'élément de compensation de pression (1) dans une paroi de l'appareil de terrain, et d'un composant support en forme de disque (4) avec une surface d'extrémité latérale (7),
le composant support en forme de disque (4) présentant dans deux zones - décalées axialement l'une par rapport à l'autre - de la surface d'extrémité (7), respectivement un bord de butée (9, 10),
un nombre (n, avec n ≥ 2) prédéfini de cavités s'étendant radialement (6) et correspondant avec le perçage axial (5) étant prévu dans le composant support en forme de disque (4),
les cavités s'étendant radialement (6) étant munies, dans la zone de la surface d'extrémité latérale (7) du composant support en forme de disque (4), d'une membrane (8) bloquant le passage de fluides mais perméable aux gaz,
la membrane (8) étant conçue de façon annulaire et fixée entre les deux bords de butée (9, 10), et
un capuchon de protection (11) étant prévu, lequel recouvre le composant support en forme de disque (4) dans la zone de la surface frontale (22) et de la surface d'extrémité latérale (7).

2. Élément de compensation de pression selon la revendication 1,
pour lequel le décalage angulaire du nombre (n) de cavités s'étendant radialement (6) est de 360°/n.

3. Élément de compensation de pression selon la revendication 1,
pour lequel quatre cavités disposées radialement (6) sont prévues dans le composant support en forme de disque (4), lesquelles cavités présentent un décalage angulaire de 90°.

4. Élément de compensation de pression selon l'une des revendications précédentes,
pour lequel il s'agit, concernant la membrane (8), d'une membrane unidirectionnelle perméable à la vapeur d'eau, hydrofuge et respirante.

5. Appareil de terrain de la technique d'automatisation avec au moins un premier espace intérieur, un élément de compensation de pression (1), tel que décrit dans au moins l'une des revendications 1 à 4, étant disposé dans la paroi (15) du boîtier (14) de l'appareil de terrain (13), lequel élément sépare l'espace intérieur (16, 18) de l'environnement extérieur (17) de l'appareil de terrain (1).

6. Appareil de terrain de la technique d'automatisation avec au moins un premier espace intérieur (16) et un deuxième espace intérieur (18), le premier espace intérieur (16) et le deuxième espace intérieur (18) étant séparés l'un de l'autre par une paroi intermédiaire (19), un élément de compensation de pression (1) tel que décrit dans au moins l'une des revendications 1 à 4 étant disposé dans la paroi extérieure d'au moins l'un des deux espaces intérieurs (16, 18).

7. Capteur de pression relative destiné à l'acquisition d'une pression à mesurer en tant que pression relative par rapport à une pression de référence régnant dans l'environnement du capteur de mesure, avec un capteur de pression relative disposé dans un boîtier (14), une alimentation en pression, par l'intermédiaire de laquelle la pression à mesurer est acheminée au capteur de pression relative, et une alimentation en pression de référence, par l'intermédiaire de laquelle la pression de référence est acheminée au capteur de pression relative, l'alimentation en pression de référence débouchant dans une ouverture réalisée dans une paroi extérieure du boîtier, un élément de compensation de pression (1) étant inséré dans l'ouverture ou l'alimentation en pression de référence, comme décrit dans au moins l'une des revendications 1 à 4.
